# EUROPEAN PATENT SPECIFICATION

(11) **EP 4 130 712 B1**
(45) Date of publication and mention of the grant of the patent: **12.06.2024**
(21) Application number: 21775473.8
(22) Date of filing: 18.02.2021
(51) Int. Cl.: G01N 15/14, H03M 7/36, H03M 7/40, G01N 21/64, H03M 7/30, G01N 15/10

(54) **INFORMATION PROCESSING SYSTEM**
INFORMATIONSVERARBEITUNGSSYSTEM
SYSTÈME DE TRAITEMENT D'INFORMATIONS

(30) Priority: 26.03.2020 JP 2020056230
(43) Date of publication of application: 08.02.2023
(73) Proprietor: Sony Group Corporation, Tokyo 108-0075 (JP)
(72) Inventor: NISHIMAKI, Yuji, Tokyo 108-0075 (JP)
(74) Representative: D Young & Co LLP
(86) International application number: PCT/JP2021/006046
(87) International publication number: WO 2021/192750

(56) References cited:
- EP-A1- 0 620 428
- EP-A1- 0 620 428
- WO-A1-2006/028156
- WO-A1-2017/203679
- JP-A- 2004 221 708
- JP-A- 2008 199 587
- JP-A- 2012 004 636
- JP-A- 2013 246 140
- US-B2- 8 751 462

## Description

### Field

The present disclosure relates to an information processing system, an information processing apparatus, and an information processing method.

### Background

In the fields of medicine, biochemistry, and the like, a flow cytometer is sometimes used to quickly measure the properties of a large amount of microparticles. The flow cytometer is a measuring device using an analysis method called flow cytometry and irradiates a microparticle such as a cell flowing through a flow cell with light and detects fluorescence or the like emitted from the microparticle.

In a next-generation flow cytometer, a fluorescence signal is multicolored in order to enable detailed analysis of cells. As such a next-generation flow cytometer, a spectral-type flow cytometer has been developed. In the spectral-type flow cytometer, a spectroscopic element such as a prism or a grating is used to disperse light emitted from a microparticle such as a cell labeled with a plurality of fluorescent dyes. The dispersed light is detected by a light receiving element array in which a plurality of light receiving elements in different detection wavelength regions are arrayed. Detection values of the light receiving elements are collected, whereby a measurement spectrum of a measurement target such as a cell is acquired.

Such a spectral-type flow cytometer has an advantage that information on fluorescence can be utilized as analysis information without leaking the information compared with a filter scheme for separating and detecting fluorescence for each wavelength region using an optical filter.

### Citation List

### Patent Literature

Patent Literature 1: JP 2009-104026 A

### Summary

### Technical Problem

When the spectral-type flow cytometer is used, it is possible to acquire a measurement spectrum in which spectra of the plurality of fluorescent dyes are mixed and measurement data representing a measurement result for each of the fluorescent dyes. Therefore, there is an advantage that analysis of a measurement target can be finely performed using both of the measurement spectrum and the measurement data. However, in order to perform such an analysis in a local environment, it is necessary to secure sufficient calculation resources in the local environment.

Therefore, it is considered to transfer data obtained in the local environment to a Cloud environment and analyze the measurement target in the Cloud environment. By cloudizing an analysis application, a detailed analysis of the measurement target can be easily performed utilizing sufficient calculation resources of the Cloud environment, data sharing and the like can be easily performed, and convenience is improved.

However, when the number of dimensions of data acquired per one sample increases due to multi-coloring of the fluorescence signal, a data amount of a sample group greatly increases. Therefore, when it is attempted to perform the analysis on the Cloud side, there is a problem in that data transfer takes a very long time.

Since the increase in the data amount directly leads to an increase in storage cost for storing the data, there is also a problem in that storage cost required for the Cloud side greatly increases due to the multi-coloring.

Therefore, the present disclosure proposes an information processing system, an information processing apparatus, and an information processing method capable of reducing the data amount. Prior art includes: EP 0 620 428 A1, which discloses the preamble of claim 1, and US 8 751 462 B2. Each of these prior art disclosures describes a prior art device.

### Solution to Problem

The invention is defined by the appended claims.

### Brief Description of Drawings

FIG. 1 is a schematic diagram illustrating a schematic configuration example of a flow cytometer used in a first embodiment.
FIG. 2 is a block diagram illustrating a schematic configuration example of a flow cytometer illustrated in FIG. 1.
FIG. 3 is a block diagram illustrating a schematic configuration example of an information processing system according to the first embodiment.
FIG. 4 is a diagram for explaining un-mixing according to the first embodiment.
FIG. 5 is a diagram illustrating a data structure example of a sample group that holds a fluorescence spectrum according to the first embodiment.
FIG. 6 is a diagram illustrating a data structure example of a sample group that holds fluorescent dye information according to the first embodiment.
FIG. 7 is a diagram illustrating a sample data example (Area) of a measurement spectrum according to the first embodiment (a sample A).
FIG. 8 is a diagram illustrating a sample data example (Area) of a measurement spectrum according to the first embodiment (a sample B).
FIG. 9 is a diagram illustrating a sample data example (Height) of a measurement spectrum according to the first embodiment (a sample A).
FIG. 10 is a diagram illustrating a sample data example (Height) of a measurement spectrum according to the first embodiment (a sample B).
FIG. 11 is a diagram for explaining an example of compression processing by a lexicographic compression method (an LZ method) according to the first embodiment.
FIG. 12 is a diagram illustrating an example of a dictionary created in the compression processing illustrated in FIG. 11.
FIG. 13 is a diagram for explaining an example of compression processing using an entropy code (a Huffman code) according to the first embodiment.
FIG. 14 is a diagram illustrating a correspondence relation between a normal bit representation and an entropy code in the compression processing illustrated in FIG. 13.
FIG. 15 is a diagram for explaining an overview of a data reducing method according to the first embodiment.
FIG. 16 is a diagram illustrating an example of generation of differential data executed in step S01 of FIG. 15.
FIG. 17 is a diagram for explaining an example of characteristics of a sample group according to the first embodiment.
FIG. 18 is a schematic diagram for explaining differential data according to the first embodiment.
FIG. 19 is a diagram for explaining a first similarity determination method according to the first embodiment.
FIG. 20 is a diagram for explaining a second similarity determination method according to the first embodiment.
FIG. 21 is a diagram illustrating an example of a difference value appearance frequency management database according to the first embodiment.
FIG. 22 is a diagram for explaining a first similar sample selection method according to the first embodiment.
FIG. 23 is a diagram for explaining a second similar sample selection method according to the first embodiment (a part 1).
FIG. 24 is a diagram for explaining the second similar sample selection method according to the first embodiment (a part 2).
FIG. 25 is a diagram for explaining the second similar sample selection method according to the first embodiment (a part 3).
FIG. 26 is a diagram for explaining the second similar sample selection method according to the first embodiment (a part 4).
FIG. 27 is a diagram for explaining the second similar sample selection method according to the first embodiment (a part 5).
FIG. 28 is a diagram for explaining an execution order example of compression, transfer, and decoding according to a third embodiment.
FIG. 29 is a diagram for explaining an execution order example of compression, transfer, and decoding according to the third embodiment more in detail.

### Description of Embodiments

Preferred embodiments of the present disclosure are explained in detail below with reference to the accompanying drawings. Note that, in this specification and the drawings, redundant explanation is omitted about components having substantially the same functional configurations by denoting the components with the same reference numerals and signs.

Note that the explanation is made in the following order.
1. First Embodiment
   1.1 Overview of a flow cytometer
   1.2 Schematic configuration example of a spectral-type flow cytometer
   1.3 Schematic configuration example of an information processing system
   1.4 About un-mixing
   1.5 About a data structure
      1.5.1 Data structure example of a measurement spectrum
      1.5.2 Data structure example of fluorescent dye information
   1.6 Sample data example
   1.7 Problem concerning sample data
   1.8 Data reducing method
      1.8.1 Reduction of an unnecessary bit representation
      1.8.2 Lexicography (LZ method)
      1.8.3 Entropy code
      1.8.4 Statistical prediction
   1.9 Problem in reversibly compressing high-dimensional data
      1.9.1 Case of a reduction of an unnecessary bit representation
      1.9.2 Case of the Lexicography (the LZ method)
      1.9.3 Case of the entropy code
      1.9.4 Case of the statistical prediction
   1.10 Data reducing method
   1.11 Data reducing method
      1.11.1 Compression/decompression of data
      1.11.2 Format of differential data
      1.11.3 Generation/restoration method for differential data
         1.11.3.1 Determination method for a similar sample
            1.11.3.1.1 First similarity determination method
            1.11.3.1.2 Second similarity determination method
         1.11.3.2 Selection method for a similar sample
            1.11.3.2.1 First similar sample selection method
            1.11.3.2.2 Second similar sample selection method
   1.12 Summary
2. Second Embodiment
   2.1 Mutual use of similarity information obtained in fluorescence spectrum/fluorescent dye information
3. Third Embodiment
   3.1 Acceleration of Cloud transfer by division compression/decoding

### 1. First Embodiment

A first embodiment of the present disclosure is explained in detail below with reference to the drawings.

### 1.1 Overview of a flow cytometer

A flow cytometer according to the present embodiment may be a device that individually analyzes samples using an analysis method called flow cytometry. In the flow cytometer, a sample is labeled with a fluorescent reagent, which emits light under a specific condition, and light emitted when excitation light is irradiated is collected as fluorescence information. Cells can be analyzed from this fluorescence information.

A general flow cytometer uses an optical filter to divide and extract, for each of wavelength regions, fluorescence radiated from a sample and adopts, as information concerning a fluorescent dye (equivalent to fluorescent dye information explained below), data obtained by measuring the fluorescence.

On the other hand, the spectral-type flow cytometer separates, without using an optical filter, fluorescence for each of wavelengths with a spectroscope configured from a prism or the like and measures light intensity for each of the wavelengths to acquire spectrum information (hereinafter referred to as measurement spectrum) of light radiated from a sample. The spectral-type flow cytometer separates the measurement spectrum for each of fluorescent dyes with processing called spectrum un-mixing (hereinafter simply referred to as un-mixing) using a fluorescence spectrum reference.

The un-mixing is a method of approximating the measurement spectrum obtained by the spectrum-type flow cytometer with a linear sum of fluorescence spectra for each of the fluorescent dyes to obtain fluorescent dye information for each of the fluorescent dyes from the measurement spectrum. The fluorescent dye information for each of the fluorescent dyes generated by the un-mixing is used for, for example, an analysis of a sample such as a cell.

Note that a fluorescence signal in the present invention is defined as a concept including both of the measurement spectrum and the fluorescent dye information.

In the present explanation, the fluorescence spectrum for each of the fluorescent dyes is referred to as fluorescence spectrum reference. The fluorescence spectrum reference is a spectrum obtained from a sample labeled with a single fluorescent dye and may include an autofluorescence spectrum obtained from an unlabeled sample. Here, the fluorescence spectrum reference may be acquired by the spectral-type flow cytometer or a catalog value or the like provided from a provider of a fluorescent dye may be used.

In the present embodiment, as the optical measuring device, the spectrum-type flow cytometer that can acquire both the measurement spectrum and the fluorescent dye information is illustrated. However, not only this, but a general flow cytometer that acquires fluorescent dye information can also be used.

Here, in a flow cytometer, there are a microchip scheme, a droplet scheme, a cuvette scheme, a flow cell scheme, and the like as a scheme for supplying a sample to an observation point (hereinafter referred to as spot.) on a flow path. In the present embodiment, a flow cytometer of the microchip scheme (partially, the flow cell scheme) is illustrated. However, the flow cytometer is not limited to this and may be a flow cytometer of another supply scheme.

As the flow cytometer, there are an analyzer type for the purpose of an analysis of a sample such as a cell and a cell sorter type for the purpose of an analysis to sorting of the sample. In the present embodiment, an analyzer-type flow cytometer is illustrated. However, the flow cytometer is not limited to this and may be a cell sorter-type flow cytometer.

Further, the present disclosure is not limited to the flow cytometer and may be various optical measuring devices that irradiate a sample with excitation light and analyze the sample based on fluorescence of the sample. For example, the present disclosure may be a microscope that acquires an image of a sample such as a tissue section on a slide.

### 1.2 Schematic configuration example of a spectral-type flow cytometer

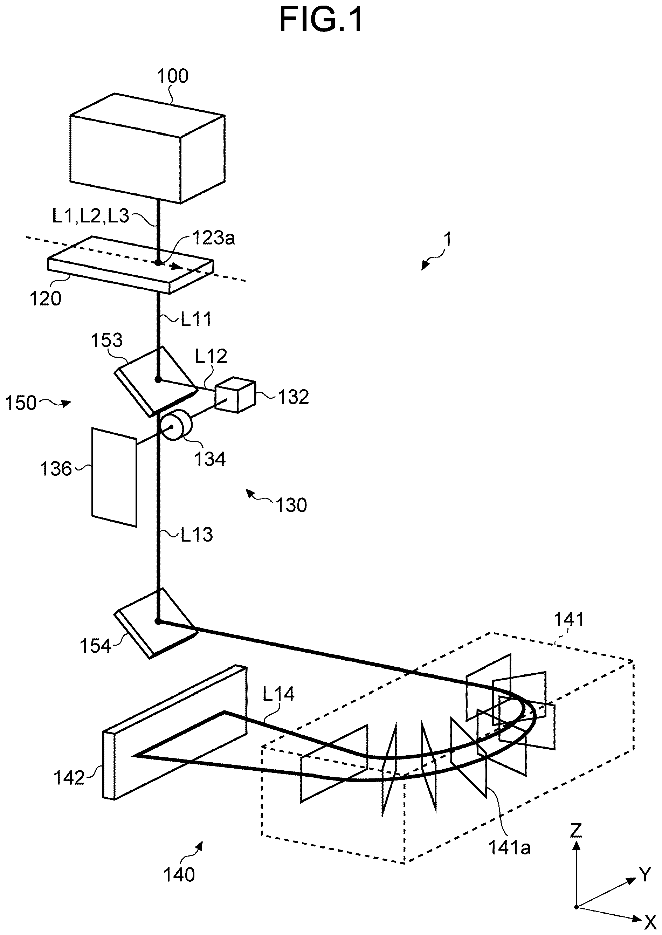

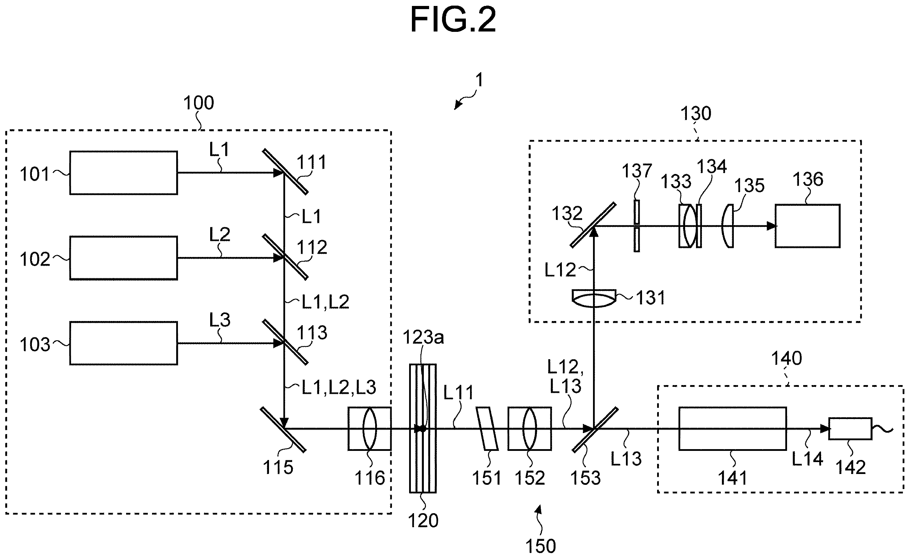

FIG. 1 is a schematic diagram illustrating a schematic configuration example of a spectral flow cytometer (hereinafter simply referred to as flow cytometer) used in the present embodiment. FIG. 2 is a block diagram illustrating a schematic configuration example of the flow cytometer illustrated in FIG. 1. For convenience of drawing, a part of optical elements is omitted in each of FIG. 1 and FIG. 2.

As illustrated in FIG. 1 and FIG. 2, a flow cytometer 1 according to the present embodiment includes a light source unit 100, a demultiplexing optical system 150, a scattered light detection unit 130, and a fluorescence detection unit 140 and detects light from a sample supplied onto a predetermined flow path using a microchip 120.

The sample is, for example, a biologically derived particle such as a cell, a microorganism, or a biologically relevant particle and includes a population of a plurality of biologically derived particles. The sample may be, for example, a biologically derived microparticle such as a cell such as an animal cell (for example, blood cells) or a plant cell, a bacterium such as Escherichia coli, a virus such as tobacco mosaic virus, a microorganism such as a fungus such as yeast, a biologically related particle constituting a cell such as a chromosome, a liposome, a mitochondria, an exosome, or various organelles (organelles), or a biologically related polymer such as a nucleic acid, a protein, a lipid, a sugar chain, or a complex thereof. Further, the sample widely includes synthetic particles such as latex particles, gel particles, and industrial particles. The industrial particles may be, for example, an organic or inorganic polymer material, a metal, or the like. Examples of the organic polymer material include polystyrene, styrene-divinylbenzene, and polymethyl methacrylate. Examples of the inorganic polymer material include glass, silica, and a magnetic material. Examples of the metal include gold colloid, aluminum, and the like. The shape of these particles is generally spherical but may be non-spherical. The size, the mass, and the like of the particles are not particularly limited.

Here, the sample is labeled (stained) with one or more fluorescent dyes. The labeling of the sample with the fluorescent dye can be performed by a known method. For example, when the sample is a cell, a fluorescently labeled antibody that selectively binds to an antigen present on the cell surface and a cell to be measured are mixed and the fluorescently labeled antibody is bound to the antigen on the cell surface, whereby the cell to be measured can be labeled with the fluorescent dye.

The fluorescently labeled antibody is an antibody to which a fluorescent dye is bound as a label. Specifically, the fluorescently labeled antibody may be a fluorescently labeled antibody obtained by binding a fluorescent dye, to which avidin is bound, to a biotin-labeled antibody by an avidin-biotin reaction. Alternatively, the fluorescently labeled antibody may be a fluorescently labeled antibody obtained by directly binding a fluorescent dye to an antibody. Note that, as the antibody, either a polyclonal antibody or a monoclonal antibody can be used. The fluorescent dye for labeling the sample is not particularly limited. At least one or more known dyes used for staining cells and the like can be used.

### (Light source unit 100)

As illustrated in FIG. 1, the light source unit 100 includes, for example, one or more (three in this example) excitation light sources 101 to 103, a total reflection mirror 111, dichroic mirrors 112 and 113, a total reflection mirror 115, and an objective lens 116.

In this configuration, the total reflection mirror 111, the dichroic mirrors 112 and 113, and the total reflection mirror 115 configure a waveguide optical system that guides excitation lights L1 to L3 emitted from excitation light sources 101 to 103 onto a predetermined optical path.

The objective lens 116 configures a condensing optical system that condenses the excitation lights L1 to L3, which are propagated on the predetermined optical path, on a spot 123a set on the flow path in the microchip 120. Note that the spot 123a is not limited to one spot, that is, the excitation lights L1 to L3 may be respectively condensed on different spots. The condensing positions of the respective excitation lights L1 to L3 do not need to coincide with the spot 123a and may be shifted back and forth on optical axes of the excitation lights L1 to L3.

In the example illustrated in FIG. 1, the three excitation light sources 101 to 103 that respectively emit the excitation lights L1 to L3 having different wavelengths are provided. As the excitation light sources 101 to 103, for example, a laser light source that emits coherent light may be used. For example, the excitation light source 102 may be a DPSS laser (Diode Pumped Solid State Laser) that irradiates a blue laser beam (peak wavelength: 488 nm (nanometer), power: 20 mW). The excitation light source 101 may be a laser diode that irradiates a red laser beam (peak wavelength: 637 nm, power: 20 mW). Similarly, the excitation light source 103 may be a laser diode that emits a near-ultraviolet laser beam (peak wavelength: 405 nm, power: 8 mW). The excitation lights L1 to L3 emitted from the excitation light sources 101 to 103 may be pulse light.

For example, the total reflection mirror 111 totally reflects the excitation light L1 emitted from the excitation light source 101 in a predetermined direction.

The dichroic mirror 112 is an optical element for matching or collimating the optical axis of the excitation light L1 reflected by the total reflection mirror 111 and the optical axis of the excitation light L2 emitted from the excitation light source 102. For example, the dichroic mirror 112 transmits the excitation light L1 reflected by the total reflection mirror 111 and reflects the excitation light L2 emitted from the excitation light source 102. For example, a dichroic mirror designed to transmit light having a wavelength of 637 nm and reflect light having a wavelength of 488 nm may be used as the dichroic mirror 112.

The dichroic mirror 113 is an optical element for matching or collimating the optical axes of the excitation lights L1 and L2 reflected from the dichroic mirror 112 and the optical axis of the excitation light L3 emitted from the excitation light source 103. For example, the dichroic mirror 113 transmits the excitation light L1 reflected by the total reflection mirror 111 and reflects the excitation light L3 emitted from the excitation light source 103. For example, a dichroic mirror designed to transmit light having a wavelength of 637 nm and light having a wavelength of 488 nm and reflect light having a wavelength of 405 nm may be used as the dichroic mirror 113.

The excitation lights L1 to L3 finally collected as light traveling in the same direction by the dichroic mirror 113 are totally reflected by the total reflection mirror 115 and made incident on the objective lens 116.

Note that a beam shaping unit for converting the excitation lights L1 to L3 into parallel light may be provided on an optical path from the excitation light sources 101 to 103 to the objective lens 116. The beam shaping unit may be configured by, for example, one or more lenses or mirrors.

The objective lens 116 condenses the excitation lights L1 to L3 made incident thereon on the predetermined spot 123a on a flow path in the microchip 120 explained below. When the spot 123a is irradiated with the excitation lights L1 to L3, which are pulsed light, while the sample is passing through the spot 123a, fluorescence is emitted from the sample and the excitation lights L1 to L3 are scattered by the sample to generate scattered lights.

In the present explanation, among the scattered lights generated from the sample in all directions, a component within a predetermined angle range traveling forward in a traveling direction of the excitation lights L1 to L3 is referred to as forward scattered light L12, a component within a predetermined angle range traveling backward in the traveling direction of the excitation lights L1 to L3 is referred to as backward scattered light, and a component in a direction deviating from the optical axes of the excitation lights L1 to L3 by more than a predetermined angle is referred to as sideward scattered light.

The objective lens 116 has, for example, a numerical aperture corresponding to approximately 30° to 40° with respect to the optical axis. A component within a predetermined angle range traveling forward in the traveling direction of the excitation lights L1 to L3 (hereinafter referred to as fluorescence L13) in the fluorescence emitted from the sample and the forward scattered light L12 are input to the demultiplexing optical system 150 arranged forward in the traveling direction of the excitation lights L1 to L3.

### (Demultiplexing optical system 150)

As illustrated in FIG. 1 and FIG. 2, the demultiplexing optical system 150 includes, for example, a filter 151, a collimator lens 152, a dichroic mirror 153, and a total reflection mirror 154 (see FIG. 1). However, the demultiplexing optical system 150 is not limited to this configuration and may be variously modified.

The filter 151 disposed on the downstream side of the microchip 120 on the optical path of the excitation lights L1 to L3 selectively blocks, for example, a part (for example, the excitation lights L1 and L3) of the excitation lights L1 to L3 in the light L11 traveling to the downstream side of the microchip 120. Here, the light traveling to downstream side of the microchip 120 includes the excitation light L1 to L3 (including forward scattered lights thereof) and fluorescence L13 radiated from the sample in the microchip 120. Therefore, the filter 151 blocks components of the excitation lights L1 and L3 and transmits a component (this is referred to as forward scattered light L12) of the excitation light L2 and the fluorescence L13.

Note that the filter 151 is disposed to be inclined with respect to the optical axis of light L16. Consequently, return light of the light L16 reflected by the filter 151 is prevented from being made incident on the scattered light detection unit 130 and the like via the objective lens 116 and the like.

The forward scattered light L12 and the fluorescence L13 transmitted through the filter 151 are, for example, converted into collimated light by the collimator lens 152 and then demultiplexed in the dichroic mirror 153. For example, the dichroic mirror 153 reflects the forward scattered light L12 in the incident light and transmits the fluorescence L13. The forward scattered light L12 reflected by the dichroic mirror 153 is guided to the scattered light detection unit 130. The fluorescence L13 transmitted through the dichroic mirror 153 is guided to the fluorescence detection unit 140.

### (Scattered light detection unit 130)

The scattered light detection unit 130 includes, for example, a plurality of lenses 131, 133, and 135 that shape the beam cross section of the forward scattered light L12 reflected by the dichroic mirror 153 and a total reflection mirror 132, a diaphragm 137 that adjusts a light amount of the forward scattered light L12, a mask 134 that selectively transmits light (for example, a component of excitation light L2) having a specific wavelength in the forward scattered light L12, and a photodetector 136 that detects light transmitted through the mask 134 and the lens 135 and made incident.

The photodetector 136 is configured by, for example, a two-dimensional image sensor or a photodiode and detects an amount and the size of light that transmitted through the mask 134 and the lens 135 and made incident. A signal detected by the photodetector 136 is input to, for example, an information processing apparatus 2 explained below.

### (Fluorescence detection unit 140)

The fluorescence detection unit 140 includes, for example, a spectroscopic optical system 141 that disperses the fluorescence L13 made incident thereon into dispersed light L14 for each of wavelengths and a photodetector 142 that detects a light amount of the dispersed light L14 for each of predetermined wavelength bands (also referred to as channel).

The spectroscopic optical system 141 includes, for example, one or more optical elements 141a such as a prism and a diffraction grating and disperses the fluorescence L13 made incident thereon into the dispersed light 7L14 emitted toward different angles for each of wavelengths.

The photodetector 142 may be configured from, for example, a plurality of light receiving units that receive light for each of channels. In that case, the plurality of light receiving units may be arrayed in one line or two or more lines in a spectroscopic direction by the spectroscopic optical system 141. For each of the light receiving units, for example, a photoelectric conversion element such as a photomultiplier tube can be used. However, a two-dimensional image sensor or the like can be used instead of the plurality of light receiving units.

A signal (a fluorescence signal) indicating a light amount of the fluorescence L13 for each of the channels detected by the photodetector 142 is input to, for example, the information processing apparatus 2 explained below.

### 1.3 Schematic configuration example of an information processing system

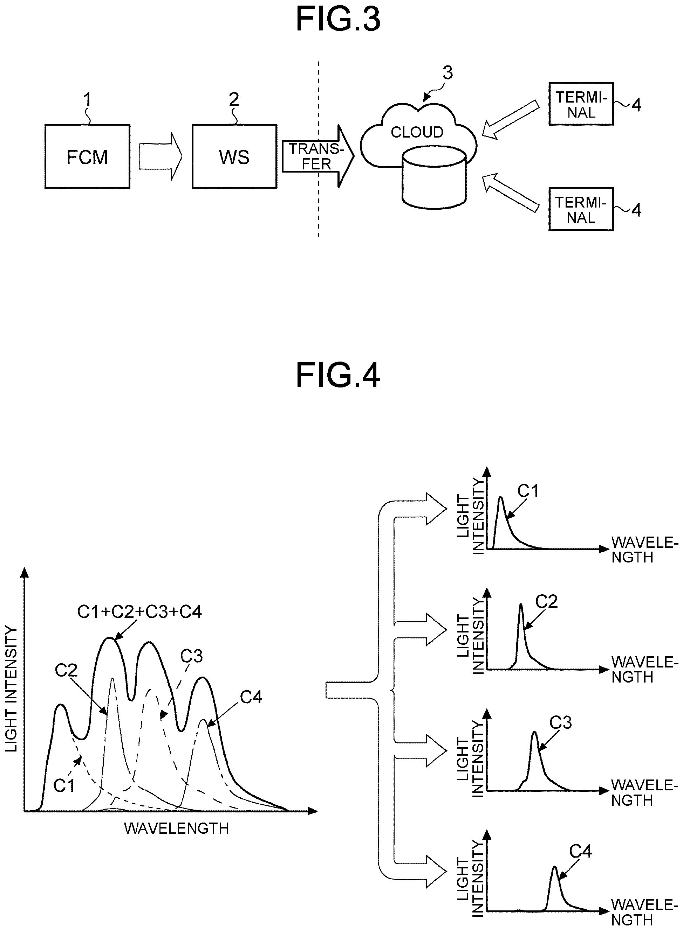

FIG. 3 is a block diagram illustrating a schematic configuration example of an information processing system according to the present embodiment. As illustrated in FIG. 3, the information processing system can be configured from, for example, the flow cytometer 1 explained above, the information processing apparatus 2, the Cloud 3, and one or more terminals 4.

The information processing apparatus 2 is configured by, for example, a personal computer or a workstation and executes acquisition of data detected by the flow cytometer 1, partial analysis work on a sample to be analyzed, and the like. The information processing apparatus 2 can be equivalent to, for example, an example of an information processing unit in claims. Note that the information processing apparatus 2 may include a transmission unit for transmitting various data via a predetermined network and a reception unit for receiving various data from the predetermined network.

The Cloud 3 is connected to the information processing apparatus 2 via a predetermined network such as a LAN (Local Area Network), the Internet, or a mobile communication network and executes a detailed analysis of a sample based on data transferred from the information processing apparatus 2.

The terminal 4 is a terminal on a user side that is configured by, for example, a personal computer, a table terminal, or a smartphone and is in charge of a detailed analysis of a sample and is a terminal for the user to perform an analysis instruction to the Cloud 3, acquisition and inspection of an analysis result obtained by the Cloud 3, and the like.

### 1.4 About un-mixing

Here, un-mixing executed in the information processing apparatus 2 and/or the Cloud 3 in the present embodiment is explained more in detail. FIG. 4 is a diagram for explaining un-mixing according to the present embodiment. As explained above, the un-mixing is processing for approximating a measurement spectrum obtained by the spectral-type flow cytometer with a linear sum of fluorescence spectrum references to obtain fluorescent dye information of a sample to be analyzed. FIG. 4 illustrates an example in which measurement spectra C1 + C2 + C3 + C4 in which fluorescence spectra C1 to C4 of respective four fluorescent dyes overlap one another are separated into the fluorescence spectra C1 to C4 (fluorescent dye information) of the respective four fluorescent dyes.

Usually, the number of dimensions of the fluorescent dye information is smaller than the number of dimensions of the measurement spectrum. Therefore, a data amount can be reduced by converting the measurement spectrum into the fluorescent dye information with the un-mixing. Note that the number of dimensions is a value equivalent to the number of types of data. For example, in the measurement spectrum, the number of dimensions can be equivalent to the number of channels and, in the fluorescent dye information, the number of dimensions can be equivalent to the number of colors.

For example, a spectral-type cell analyzer ID7000 (registered trademark) manufactured by Sony Corporation (registered trademark) can convert a measurement spectrum of maximum 188 channels (that is, the number of dimensions = 188) into fluorescent dye information of 44 colors (that is, the number of dimensions = 44). However, the number of dimensions of the fluorescent dye information may be a value that changes according to the number of fluorescent reagents for labeling the sample.

### 1.5 About a data structure

Here, the data structure of each of the measurement spectrum and the fluorescent dye information is explained below. Note that, in the following explanation, a data structure of a measurement spectrum output from a flow cytometer 1 that generates a measurement spectrum of maximum 188 channels using seven excitation light sources (that is, seven types of excitation lights having different wavelengths; in FIG. 2, three excitation light sources 101 to 103) and a 32-channel photodetector 142 and a data structure of fluorescent dye information in the case where the measurement spectrum is converted into fluorescent dye information of 44 colors are explained with reference to examples.

### 1.5.1 Data structure example of a measurement spectrum

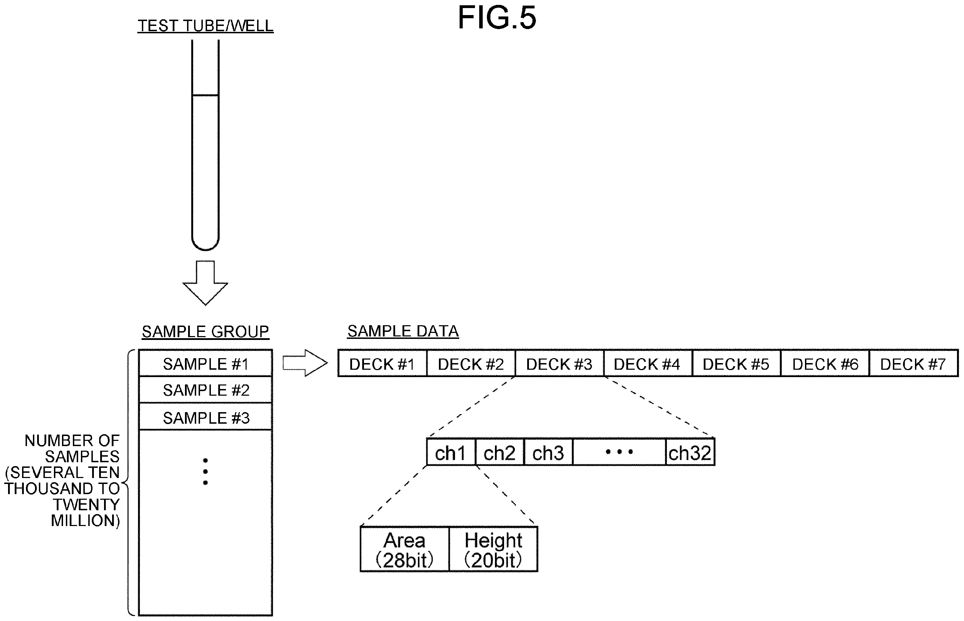

FIG. 5 is a diagram illustrating a data structure example of a sample group that holds a fluorescence spectrum according to the present embodiment. Here, the sample group indicates a population of samples to be measured by the flow cytometer 1. As illustrated in FIG. 5, the sample group is configured from sample data for each of samples obtained from a test tube or a well and measured by the flow cytometer 1. The sample data may be a measurement spectrum obtained by measuring the individual samples. Approximately several ten thousand to twenty million or more samples can be included in one sample group.

Each sample data has a unit called a deck. Each deck corresponds to one excitation light source (that is, one excitation light). Therefore, in this example, one sample data has seven decks #1 to #7.

Each of the decks #1 to #7 is configured from maximum thirty-two channels ch1 to ch32. However, in each of the decks #1 to #7, since fluorescence does not appear in a channel equivalent to a wavelength shorter than the excitation light, not all the decks #1 to #7 have thirty-two channels. In this example, entire one sample data configures data of maximum 188 channels in total.

Each of the channels is configured from data of Area (area) and Height (height). However, in addition to these or instead of one of these, Width (width) may be used. Note that Area (area) may be a value calculated by Height (height) × Width (width) or a value obtained by multiplying the value by a predetermined coefficient.

Here, assuming that Area is 28 bits, Height is 20 bits, and the number of samples is 20 million, a data amount of sample data of maximum 188 channels is an enormous data amount of approximately 23 gigabytes.

### 1.5.2 Data structure example of fluorescent dye information

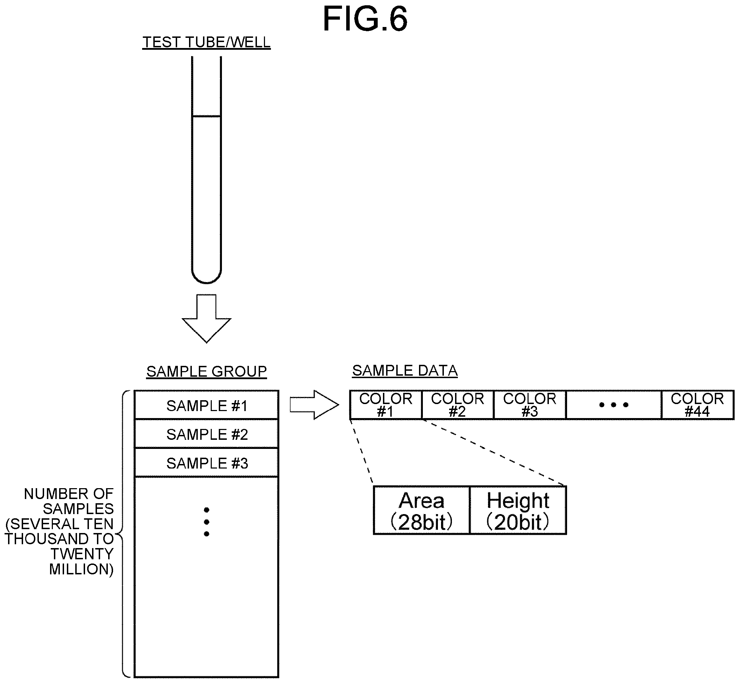

FIG. 6 is a diagram illustrating a data structure example of a sample group that holds fluorescent dye information according to the present embodiment. In the present example, like the sample group in FIG. 5, the sample group is configured from sample data for each of samples measured by the flow cytometer 1. Sample data of approximately several ten thousand to 20 million or more samples can be included in the sample group. However, in the present example, the sample data may be fluorescent dye information obtained by fluorescently separating measurement spectra obtained from individual samples.

In the present example, each of the sample data is configured from color information of maximum 44 colors #1 to #44 and each of the colors #1 to #44 includes data of Area (area) and Height (height). However, in addition to these or instead of one of these, Width (width) may be used.

Here, assuming that Area is 28 bits, Height is 20 bits, and the number of samples is 20 million, a data amount of the sample data of maximum 44 colors is also an enormous data amount of approximately 5 gigabytes.

Note that the data structures of the measurement spectrum and the fluorescent dye information explained above are merely examples. It is not essential that the measurement spectrum and the fluorescent dye information have the data structures explained above. That is, the present embodiment can be applied to various data if there is a group that holds a large amount of high-dimensional data as data to be transferred and/or data to be saved (In the present invention, the measurement spectrum and the fluorescent dye information) and a type of the high-dimensional data held by the group is data having a data structure smaller than the entire high-dimensional data. In an example not forming part of the present invention, the present example can also be applied to fluorescent dye information acquired by a general flow cytometer in which an optical filter is used.

### 1.6 Sample data example

Subsequently, the sample data according to the present embodiment is explained with reference to several examples.

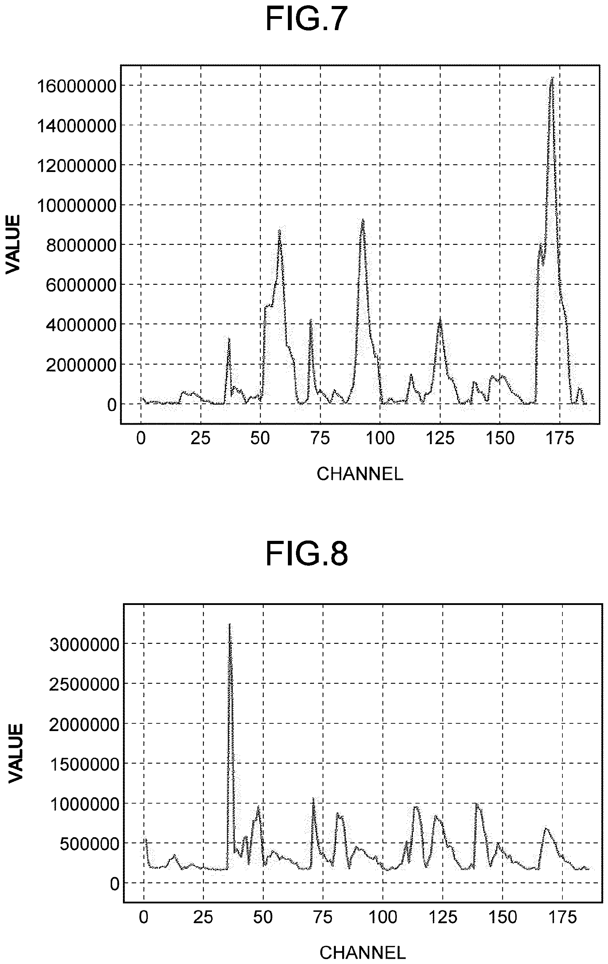

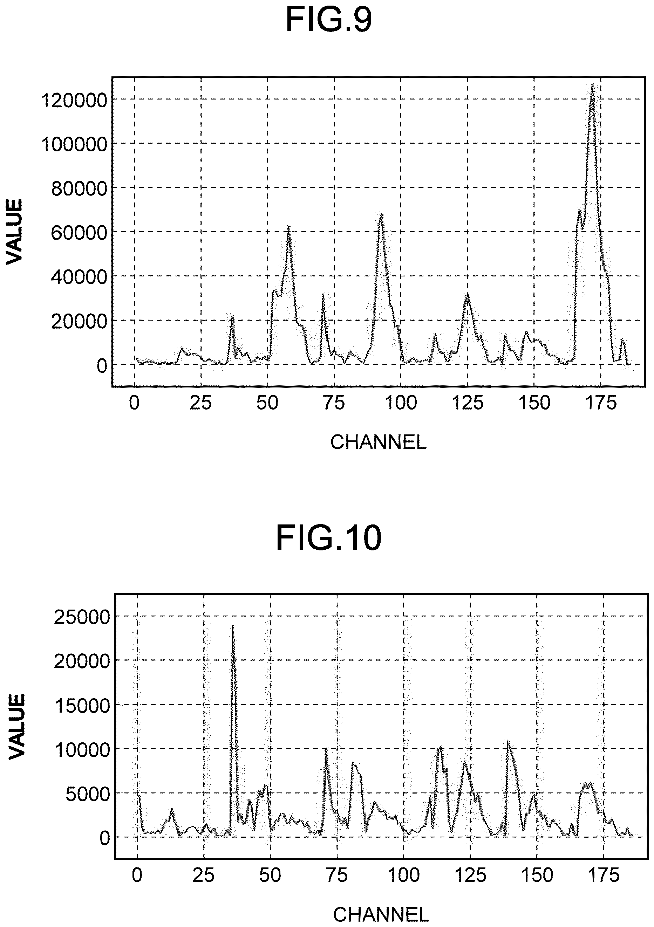

FIG. 7 and FIG. 8 are diagrams illustrating sample data examples (Area) of a measurement spectrum according to the present embodiment. FIG. 9 and FIG. 10 are diagrams illustrating sample data examples (Height) of a measurement spectrum according to the present embodiment. Note that the sample data example (Area) illustrated in FIG. 7 and the sample data example (Height) illustrated in FIG. 9 are data acquired from the same sample A and the sample data example (Area) illustrated in FIG. 8 and the sample data example (Height) illustrated in FIG. 10 are data acquired from the same sample B.

As illustrated in FIG. 7 and FIG. 8, the sample data for Area of the measurement spectrum respectively have data of maximum 188 channels and each of the channels is represented by 28-bit data.

Similarly, as illustrated in FIG. 9 and FIG. 10, the sample data for Height of the measurement spectrum respectively have data of maximum 188 channels and each of the channels is represented by 20-bit data.

### 1.7 Problem concerning sample data

As explained above, in the flow cytometer 1 according to the present embodiment, the number of dimensions per one sample acquired by multi-coloring increases. Accordingly, the data of the sample group increases. In the flow cytometer 1, an analysis environment is cloudized for improvement of convenience and an advanced analysis (see FIG. 3).

When the analysis environment is cloudized, it is necessary to transfer data to be analyzed (a fluorescence signal, that is, a measurement spectrum and/or fluorescent dye information) from the flow cytometer 1 side (the information processing apparatus 2) to the Cloud 3. However, since a data amount of the measurement spectrum and/or the fluorescent dye information is enormous as explained above, an enormous transfer time occurs if it is attempted to transfer these data to the Cloud 3.

After the data transfer, it is necessary to save the transferred data (fluorescence signal, that is, the measurement spectrum and/or the fluorescent dye information) on the Cloud 3 side. However, to save the data, it is necessary to secure an enormous capacity of a storage on the Cloud 3 side and storage cost required on the Cloud 3 side becomes enormous.

As explained above, when the flow cytometer 1 is multicolored, problems such as an increase in a data transfer time and an increase in storage cost occur because of an increase in data amount due to multidimensionalization.

Therefore, in the present embodiment, a method of reducing a data amount of data (for example, a measurement spectrum) output from the flow cytometer 1 or data (for example, fluorescent dye information) generated from the data, the data being data to be transferred or saved (a fluorescence signal, that is, the measurement spectrum and/or the fluorescent dye information), is explained with reference to several examples.

### 1.8 Data reducing method

When a data amount of the measurement spectrum or the fluorescent dye information obtained from the flow cytometer 1 is reduced, it is required to restore the data before the data amount reduction at the time of an analysis. Therefore, in the present embodiment, a data reducing method by reversible compression is proposed as a data amount reducing method. Several examples are explained below about a reversible compression method that can be used in the present embodiment.

### 1.8.1 Reduction of an unnecessary bit representation

First, as a first reversible compression method, a method of compressing by reducing an unnecessary bit representation is illustrated. This method is a method of, when a numerical value represented as bits, reducing the number of unused bits and representing data with a smaller number of bits. For example, in a general computer, a structure (also referred to as a type) such as System.int32 is widely used.

Here, a dynamic range that can be represented by System.int32 is in a range of '-2³¹' to '2³¹-1', However, if a numerical value to be represented is present only up to 8 bits of '0' to '255', the dynamic range of System.int32 is not used up. Therefore, the unused bits are wasted.

Therefore, in such a case, data can be reduced from 32 bits to 8 bits by replacing a structure to be used with System.uint8. In such a method of reducing unused bits, it is possible to restore original data by adding bits corresponding to the reduced bits.

### 1.8.2 Lexicography (LZ method)

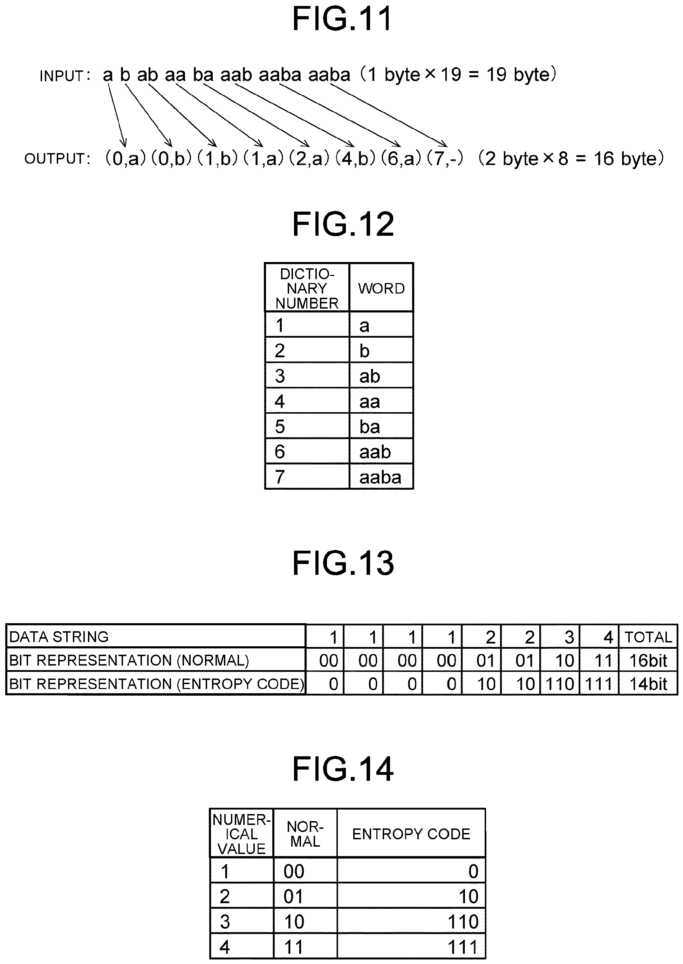

As a second reversible compression method, a lexicographic compression method (an LZ method) is conceivable. The LZ method is a method of reducing an amount of data by representing data with a dictionary. An example of compression processing by the LZ method is illustrated in FIG. 11 and FIG. 12.

In the LZ method, for example, when the input data 'a b ab aa ba aab aaba aaba' illustrated in FIG. 11 is input, a dictionary illustrated in FIG. 12 is sequentially created by reading the input data in order from the top. Then, when there is data registered in the dictionary in the process of reading the input data from the top, as illustrated in FIG. 11, output data '(0, a) (0, b) (1, b) (1, a) (2, a) (4, b) (6, a) (7, -)' is represented using dictionary numbers registered in the dictionary illustrated in FIG. 12. Consequently, for example, input data of 19 bytes (= 1 byte × 19) is compressed to output data of 16 bytes (= 2 bytes × 8).

In such an LZ method, the original data (input data) can be restored by referring to the dictionary based on the output data.

### 1.8.3 Entropy code

As a third reversible compression method, a compression method using an entropy code is conceivable. The compression method using the entropy code is a method of representing data having a high appearance frequency with a short bit length and representing data having a low appearance frequency with a long bit length to reduce data. An example of compression processing using an entropy code (a Huffman code) is illustrated in FIG. 13 and FIG. 14.

As illustrated in FIG. 13, when a data string '1 1 1 1 2 2 3 4' is represented by normal 2 bits, since the data string is represented as '00 00 00 00 01 01 10 11', and a total number of bits of the data string is 16 bits. On the other hand, when an entropy code illustrated in FIG. 14 is used, since the data string '1 1 1 1 2 2 3 4' is represented as '0 0 0 0 10 10 110 111', the total number of bits of the data string is reduced to 14 bits.

Such a compression method using the entropy code can also restore the data string represented by the entropy code to a data string represented by normal 2 bits based on a correspondence relation (FIG. 14) between the entropy code and the normal bit representation.

Note that, in the compression method using the entropy code, since the bit length is determined according to an appearance probability of data, in particular, when there is a bias in an appearance frequency, the data can be greatly reduced.

### 1.8.4 Statistical prediction

As a fourth reversible compression method, a compression method using statistical prediction is conceivable. The compression method using statistical prediction is a method of reducing data by predicting data that appears next from observed data. For example, data in which 'abcabc' continues is conceived. When this data is compressed by an entropy code, since there is no bias of an appearance frequency of 'a', 'b', and 'c', a data reduction ratio cannot be increased. On the other hand, when the data is encoded using a probability that 'b' appears next to 'a', since a bias can be imparted, the data reduction ratio can be increased.

Note that two or more of the reversible compression methods illustrated above can be used in combination. For example, in a compression method such as zip, the lexicographic compression method (the LZ method) and the compression method using the entropy code are combined to compress data. In the present embodiment, various reversible compression methods and combinations thereof can be used without being limited to the reversible compression methods explained above.

### 1.9 Problem in reversibly compressing high-dimensional data

Subsequently, problems in reversibly compressing high-dimensional data such as a sample group using each of the reversible compression methods illustrated above are explained.

### 1.9.1 Case of a reduction of an unnecessary bit representation

In the method of compressing by reducing an unnecessary bit representation illustrated as the first reversible compression method, a dynamic range of a structure that saves data is calculated from a value that can be taken by a device. Therefore, there is a problem in that a reduction ratio cannot be effectively achieved except for extreme measurement data.

### 1.9.2 Case of the Lexicography (the LZ method)

In the lexicographic compression method (the LZ method) illustrated as the second reversible compression method, it is difficult to grasp features of a spectrum shape using a dictionary for data that changes for each of samples such as a fluorescence spectrum. Therefore, there is a problem in that it is difficult to effectively increase a reduction ratio. Even if one sample data is registered in the dictionary, it is difficult to increase the reduction ratio because a spectral shape of other sample data less easily completely coincides. Similarly, even if sample data is finely divided and registered in the dictionary, it is difficult to increase the reduction ratio as expected because perfect coincidence is rare.

### 1.9.3 Case of the entropy code

In the compression method using the entropy code illustrated as the third reversible compression method, when data having a wide dynamic range such as 28 bits or 20 bits such as sample data is targeted, there are many variations of numerical values that can be taken and a bias of an appearance frequency less easily occurs. Therefore, there is a problem in that it is difficult to increase the reduction ratio.

### 1.9.4 Case of the statistical prediction

In the compression method using the statistical prediction illustrated as the fourth reversible compression method, it is difficult to predict the next value from an observed value for a spectral shape such as a fluorescence spectrum. Therefore, there is a problem in that it is difficult to generate a highly accurate prediction model and it is difficult to increase the reduction ratio.

As explained above, in the existing reversible compression method explained above, there is a problem in that effective data reduction cannot be performed on high-dimensional data such as a sample group.

### 1.10 Data reducing method

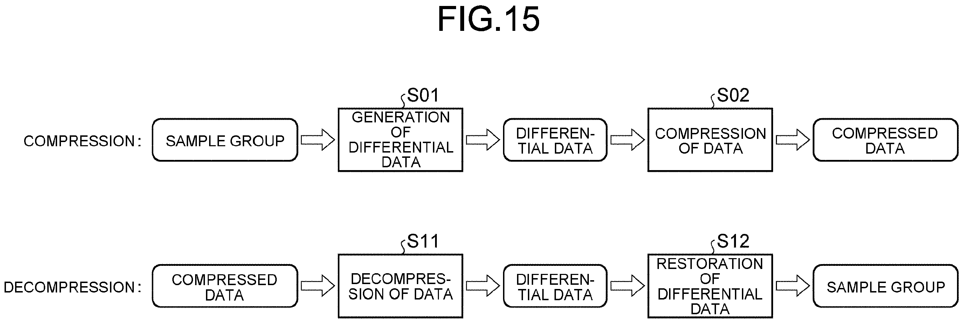

Therefore, in the present embodiment, the data reduction ratio can be effectively increased by using characteristics of a sample group. FIG. 15 is a diagram for explaining an overview of a data reducing method according to the present embodiment. Note that a compression operation in the data reducing method illustrated below may be realized, for example, by the information processing apparatus 2 executing a predetermined program. A decompression operation in the data reducing method may be realized, for example, by the Cloud 3 executing a predetermined program. That is, in the present embodiment, the information processing apparatus 2 can also function as a difference calculation unit and a compression unit and the Cloud 3 can also function as a decompression unit and a restoration unit.

As illustrated in FIG. 15, in the present embodiment, in order to use the characteristics of the sample group at the time of compression, the generation of differential data (S01) is executed before the data compression (S02). Similarly, at the time of decompression, restoration (S12) of decompressed (S11) differential data is executed. In the generation of the differential data (S01), a difference between samples in the sample group is calculated. Note that the compressed data generated in the data compression (S02) may be transferred to the Cloud 3 or may be saved in a recording device (also referred to as a storage unit) included in the information processing apparatus 2.

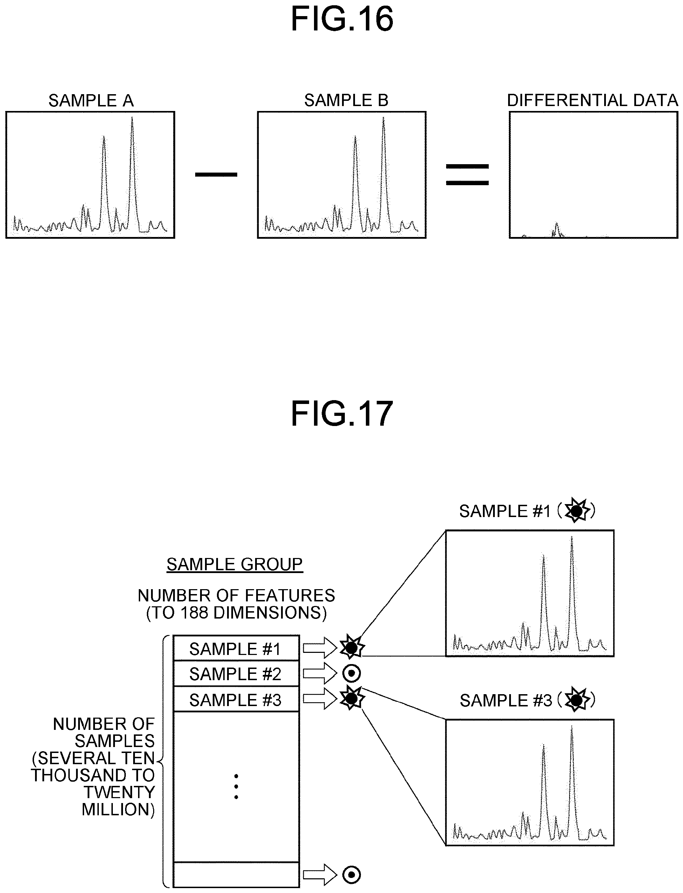

A reason for generating the differential data is to increase an effect of reducing compression by calculating a difference between samples having similar spectral shapes. An example of the generation of the differential data executed in step S01 of FIG. 15 is illustrated in FIG. 16. In the example illustrated in FIG. 16, it is assumed that a sample A and a sample B are samples having similar spectral shapes. As illustrated in FIG. 16, a dynamic range in differential data can be narrowed by calculating the difference between the samples A and B having the similar spectral shapes. Note that the dynamic range referred to herein may be the difference between a minimum value and a maximum value. By narrowing the dynamic range, it is possible to increase a data reduction effect of the method of compressing by reducing unnecessary bit representation or the compression method using the entropy code.

As a reason for calculating the difference between the samples in the sample group, the characteristics of the sample groups are related. FIG. 17 is a diagram for explaining an example of the characteristics of the sample group according to the present embodiment.

As illustrated in FIG. 17, as the characteristics of the sample group, first, the number of types (for example, the number of cell types) of the samples in the sample group is overwhelmingly smaller than the number of samples (for example, the number of cells) of the entire sample group. Several ten thousand to several ten million samples are present in the sample group. The number of types of the samples included in the sample group is approximately several hundred and is a value smaller than the number of samples in the sample group. Therefore, concerning any sample, it is extremely highly likely that a sample having characteristics similar to characteristics of the sample is present.

As a first characteristic, samples of the same type have similar feature values. In the example illustrated in FIG. 17, when a sample #1 and a sample #3 are samples (cells) of the same type, sample data of the samples have similar spectral shapes.

In this way, when the entire sample group is observed in units of samples, a redundant portion is present. Therefore, in the present embodiment, the data reduction ratio is increased by removing the redundant portion using the difference.

### 1.11 Data reducing method

Next, a data reducing method according to the present embodiment is explained below with reference to specific examples. Note that, in the following explanation, a data reducing method in the compression and the decompression illustrated in FIG. 15 is explained.

### 1.11.1 Compression/decompression of data

In the data compression/decompression illustrated in FIG. 15, the reversible compression methods explained above or a combination the reversible compression methods can be used. It is possible to calculate differential data advantageous in a data reduction by changing a method of determining similarity between samples explained below according to a reversible compression method in use.

### 1.11.2 Format of differential data

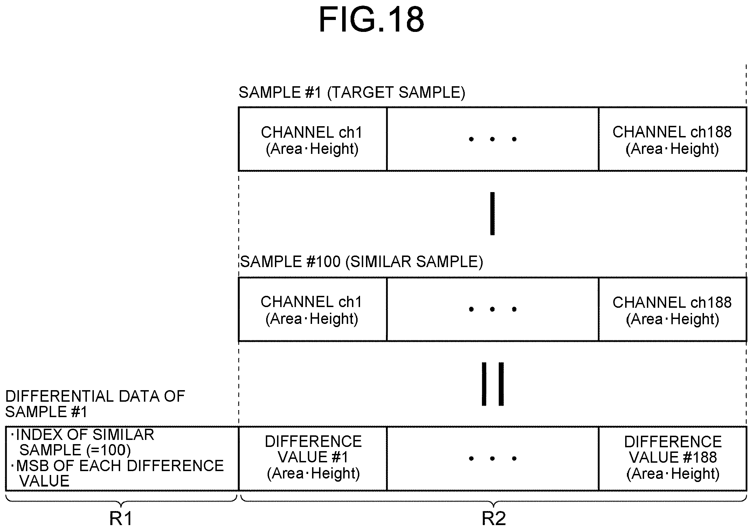

FIG. 18 is a schematic diagram for explaining differential data according to the present embodiment. Note that FIG. 18 illustrates a case where a sample #100 is specified as a sample similar to the sample #1 and the sample #1 is compressed into differential data.

As illustrated in FIG. 18, the differential data according to the present embodiment is configured from, for example, a header region R1 and a data region R2.

In the data region R2, for example, a difference value for each dimension (channel) calculated by calculating a difference between sample data for each of dimensions (channels) is stored.

In the header region R1, an index for specifying the samples, the difference of which is calculated, is stored. Note that, when a method of compressing by reducing unnecessary bit representation is used as the reversible compression method, information for specifying a most significant bit (MSB) in a difference value of each of dimensions is also stored in the header region R1.

An index of a similar sample in the header region R1 is used when the sample data of the sample #1 is restored to original data. Note that, when a sample similar to the sample #1 is not found from the sample group, instead of the index of the similar sample, a specific numerical value (For example, '0') allocated in advance as a value indicating that a similar sample is absent may be stored in the header region R1.

According to such a data format, although a data amount for the header region R1 is increased compared with original data, a data amount stored in the data region R2 can be significantly reduced. Therefore, as a result, a data amount can be significantly reduced compared with the original data.

### 1.11.3 Generation/restoration method for differential data

Subsequently, a generation method and a restoration method for differential data according to the present embodiment are explained. Note that, In the following explanation, a similar sample determination method and a similar sample selection method are specifically described.

### 1.11.3.1 Determination method for a similar sample

First, a method (a similarity determination method) for determining which sample is most similar to a certain sample when a plurality of samples are given is explained. As explained above, since the sample data is the multidimensional data, in general, similarity between two samples can be determined using a Euclidean distance, cosine similarity, or the like. However, in the present embodiment, since a difference value between samples determined as being similar is data to be compressed, compression efficiency can be changed according to in what kind of method similarity between two samples is determined, in other words, by appropriately selecting a similarity determination method. This means that the compression efficiency can be controlled by selecting a similarity determination method and designing a difference value. Therefore, in the present embodiment, in addition to the general similarity determination method (a Euclidean distance, cosine similarity, or the like) explained above, the following two methods are illustrated.

### 1.11.3.1.1 First similarity determination method

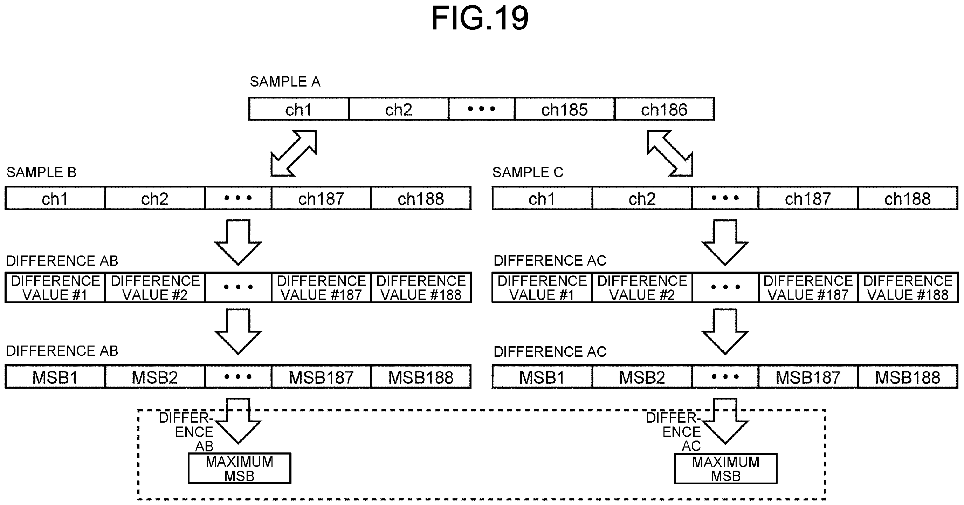

As a first similarity determination method, a method of obtaining a difference having a narrow dynamic range is illustrated. FIG. 19 is a diagram for explaining the first similarity determination method according to the present embodiment. In FIG. 19, it is determined which of a sample B and a sample C is more similar to a sample A is illustrated.

As illustrated in FIG. 19, in the first similarity determination method, first, difference values of samples are calculated. In this calculation, for example, difference values from all the other samples are calculated for the samples. In the example illustrated in FIG. 19, a difference value from the sample B and a difference value from the sample C are calculated for the sample A.

Subsequently, a most significant bit (MSB) is specified about a data set (difference values #1 to #188) of the difference values calculated for the samples. In the example illustrated in FIG. 19, when a data set of difference values of the sample A and the sample B is represented as a difference AB and a data set of difference values of the sample A and the sample C is represented as a difference AC, MSB of the difference values are specified for each of the difference AB and the difference AC.

Next, a sample of sample data used in calculating a data set including a minimum MSB among maximum MSB specified for respective data sets is specified as a similar sample. In the example illustrated in FIG. 19, when the MSB of the difference AB is smaller than the MSB of the difference AC, the sample B is specified as a sample similar to the sample A.

Note that, when there is a plurality of data sets including the minimum MSB, for example, a sample having the smallest index attached to the sample may be selected.

As explained above, by determining similarity between samples to be a combination of samples, a MSB of a difference value of which is the minimum, for example, it is possible to exert, at the maximum, compression efficiency of a method of compressing by reducing unnecessary bit representation.

Note that, when the differential data is compressed by the method of compressing by reducing unnecessary bit representation, information for specifying MSB of the difference values may be stored in the header region R1.

### 1.11.3.1.2 Second similarity determination method

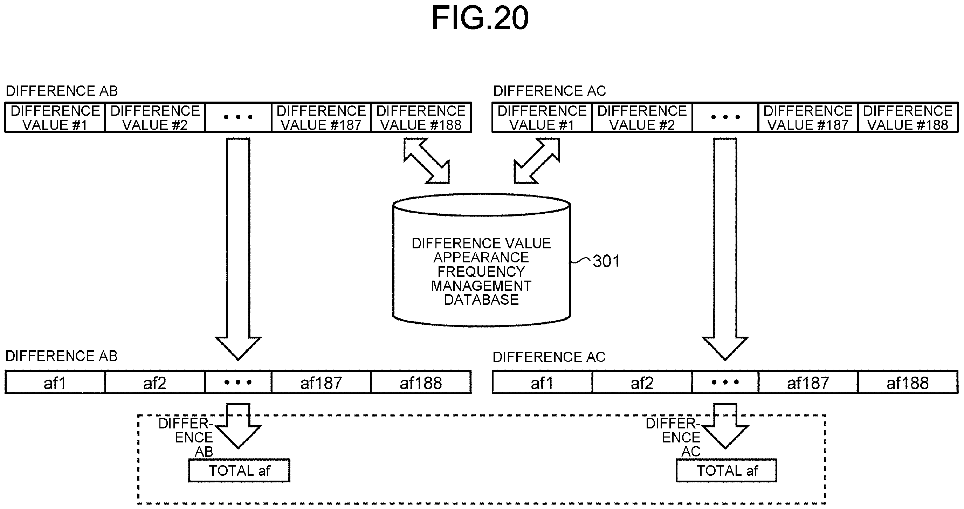

As a second similarity determination method, a method of obtaining a difference having high entropy is illustrated. FIG. 20 is a diagram for explaining a second similarity determination method according to the present embodiment. In FIG. 20, it is determined which of the sample B and the sample C is similar to the sample A.

In the second similarity determination method, a method of generating a difference between samples may be similar to the first similarity determination method. Therefore, detailed explanation of the method is omitted here.

As illustrated in FIG. 20, in the second similarity determination method, first, appearance frequencies (also referred to as the number of times of appearance) of the respective values of the difference values #1 to #188 included in the difference AB and the difference values #1 to #188 included in the difference AC are managed using a difference value appearance frequency management database 301. This management may be realized, for example, every time a difference value in each dimension in the difference AB and the difference AC is calculated, by incrementing an appearance frequency of the same value as the difference value by 1 in the difference value appearance frequency management database 301. Note that the difference value appearance frequency management database 301 may be a data base storing appearance frequencies of difference values calculated for the same sample group in the past. That is, the difference value appearance frequency management database 301 may be created for each of sample groups or for each execution of similarity determination processing for the same sample group. However, the difference value appearance frequency management database 301 is not limited this.

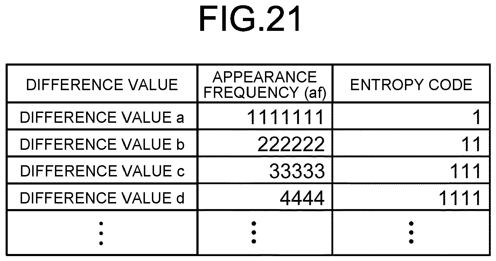

In FIG. 21, an example of the difference value appearance frequency management database according to the present embodiment is illustrated. As illustrated in FIG. 21, in the difference value appearance frequency management database 301, appearance frequencies are managed for each value of difference values. Entropy codes having different bit lengths are allocated according to the appearance frequencies. The entropy code assignment method may be the same method as the compression method using the entropy code.

Next, in the second similarity determination method, appearance frequencies of the difference values #1 to #188 are specified for each of the difference AB and the difference AC. A total value of the specified appearance frequencies is calculated for each of the difference AB and the difference AC. A sample of sample data used to create a data set having a larger calculated total value is specified as a similar sample. In the example illustrated in FIG. 20, when a total value of appearance frequencies of the difference AB is larger than a total value of appearance frequencies of the difference AC, the sample B is specified as a sample similar to the sample A.

This is explained using another example. For example, when five samples A, B, C, X, and Y are present in a sample group and a similar sample of the sample A is found from the five samples after the sample X and the sample Y are determined as being similar, an appearance frequency specified from a difference value between the sample X and the sample Y is stored in the difference value appearance frequency management database 301. When a similar sample similar to the sample A is found in this state, a sum of appearance frequencies af1 to af188 of difference values in data sets of the respective differences AB, AC, AX, and AY is calculated. A sample of a data set having a largest total value is specified as a similar sample similar to the sample A.

The two similarity determination methods are illustrated above. However, in the present embodiment, a similar sample does not always have to be determined. When a preferable value is obtained in a MSB or a total appearance frequency in original data than in a data set of difference values, the original data may be directly used as data to be compressed without calculating a difference. In this case, information indicating that data in the data region R2 is the original data may be stored in the header region R1 instead of an index indicating a similar sample.

### 1.11.3.2 Selection method for a similar sample

Next, a method of selecting a similar sample is explained. As a method of selecting a similar sample, for example, a method using general clustering and a method using a dictionary can be illustrated.

### 1.11.3.2.1 First similar sample selection method

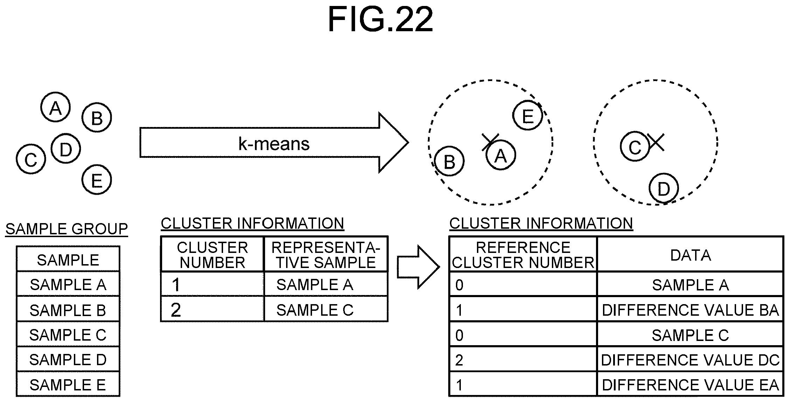

The method using clustering illustrated as a first similar sample selection method is a method of selecting representative samples from representative points of clusters and representing samples with differences from the representative samples. FIG. 22 is a diagram for explaining a first similar sample selection method according to the present embodiment. In FIG. 22, the case where k-means clustering is used as a clustering method is illustrated.

As illustrated in FIG. 22, in the first similar sample selection method, clustering by the k-means method is executed on a sample group. Representative samples are determined from generated clusters. In the example illustrated in FIG. 22, five samples of samples A to E are divided into two clusters of a cluster including the samples A, B, and E and a cluster including the samples C and D. The sample A and the sample C closest to the centers of the clusters are selected as representative samples of the respective clusters.

In the first similar sample selection method, samples other than the representative samples are represented by differences from the representative samples. In the example illustrated in FIG. 22, the samples B and E are represented by differences from the representative sample A. The sample D is represented by a difference from the representative sample C.

### 1.11.3.2.2 Second similar sample selection method

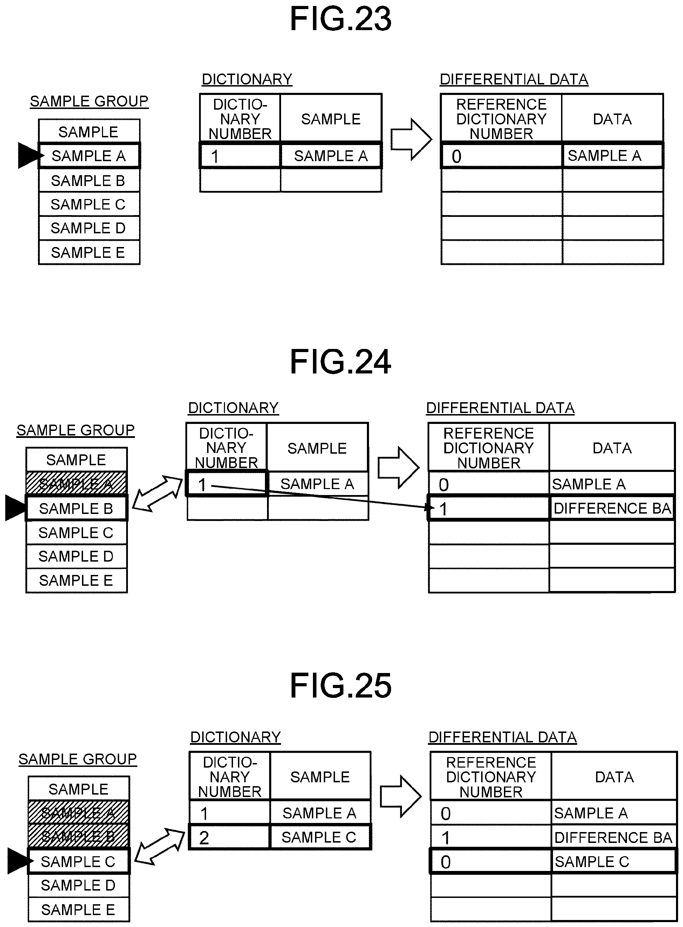

The method using a dictionary exemplified as a second similar sample selection method is a method of constructing a dictionary while reading a sample group from the top and generating a difference using the dictionary. FIG. 23 to FIG. 27 are diagrams for explaining a second similar sample selection method according to the present embodiment. Note that, in FIG. 23 to FIG. 27, the case where five samples of samples A to E are included in a sample group is illustrated.

In the second similar sample selection method, a dictionary in an initial state may be in an empty state, that is, in a state where nothing is registered. In the second similar sample selection method, as illustrated in FIG. 23, first, as an input, samples in a sample group are read from the top in order. Therefore, in a first stage, sample data of the sample A at the top in the sample group is read. Next, the read sample data of the sample A is registered in the dictionary with a dictionary number #1. As differential data of the sample A, the sample data of the sample A is directly output. At that time, since the differential data of the sample A is not a difference value, a specific numerical value (for example, '0') allocated in advance as a value indicating that the differential data is not a difference value is stored in a reference dictionary number in the header region R1.

Next, as illustrated in FIG. 24, sample data of the next sample B in the sample group is read as an input. A difference between the read sample B and the sample A is calculated. When it is determined from the read difference value between the sample B and the sample A that the sample B is similar to the sample A, a difference BA calculated by subtracting the sample A from the sample B is output as differential data of sample B. A reference dictionary number (= 1) for specifying the sample A used for the calculation of the difference value is stored in a reference dictionary number in the header region R1.

Next, as illustrated in FIG. 25, sample data of the next sample C in the sample group is read as an input. A difference between the read sample C and the sample A is calculated. When it is determined from the difference value between the read sample C and the sample A that the sample C is not similar to the sample A, sample data of the sample C is registered in the dictionary with a dictionary number #2. As differential data of the sample C, the sample data of the sample C is directly output. At that time, since the differential data of the sample C is not a difference value, a specific numerical value (for example, '0') allocated in advance as a value indicating that the differential data is not a difference value is stored in a reference dictionary number in the header region R1.

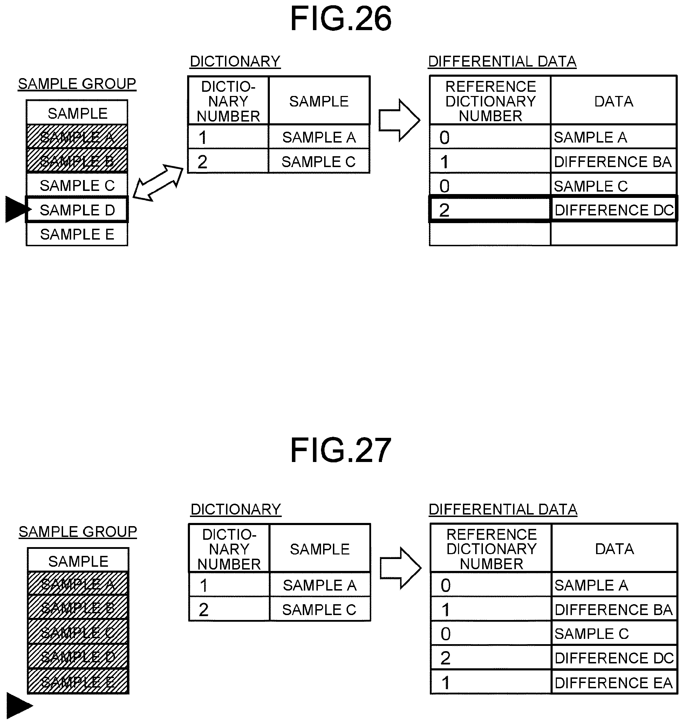

Next, as illustrated in FIG. 26, sample data of the next sample D in the sample group is read as an input. A difference between the read sample D and the sample A and a difference value between the sample D and the sample C are respectively calculated. When it is determined from the calculated difference values that the sample D is similar to the sample C, a difference DC calculated by subtracting the sample C from the sample D is output as differential data of the sample D. A reference dictionary number (= 2) for specifying the sample C used for calculating the difference value is stored in a reference dictionary number in the header region R1.

Thereafter, by repeatedly executing the same operation, differential data including a reference dictionary number in a header is finally generated for all samples as illustrated in FIG. 27.

### 1.12 Summary

As explained above, according to the present embodiment, since data (a sample group) to be compressed can be compressed according to characteristics of the data, it is possible to reduce a data transfer time or prevent an increase in the data transfer time and reduce storage cost necessary for saving of the data or prevent an increase in the storage cost.

For example, even when a sample group acquired from the multicolored next-generation flow cytometer 1 is transferred from the information processing apparatus 2 to the Cloud 3, it is possible to reduce a transfer time of the sample group or prevent an increase in the transfer time. By applying the data reducing method explained above to a sample group to be stored in the Cloud 3, it is also possible to achieve a reduction in storage cost necessary for saving of the sample group or prevent an increase in the storage cost.

### 2. Second Embodiment

Subsequently, a second embodiment of the present disclosure is explained. Note that, since configurations and operations of a flow cytometer and an information processing system according to the present embodiment may be similar to those of the embodiment explained above, detailed explanation thereof is omitted here.

2.1 Mutual use of similarity information obtained in fluorescence spectrum/fluorescent dye information The data to be compressed in the invention is the fluorescence spectrum and the fluorescent dye information. Therefore, when both the fluorescence spectrum and the fluorescent dye information are compressed, it can be necessary to execute generation of differential data (equivalent to step S01 in FIG. 15) in each of the compression of the fluorescence spectrum and the compression of the fluorescent dye information.

However, the fluorescence spectrum and the fluorescent dye information to be compressed are a fluorescence spectrum measured from the same sample group and fluorescent dye information generated from the fluorescence spectrum. Therefore, samples determined to have high similarity in the fluorescence spectrum are extremely highly likely to be determined to have high similarity in the fluorescent dye information as well. This is because the number of dimensions is different between the fluorescence spectrum and the fluorescent dye information but types of samples represented the fluorescence spectrum and the fluorescent dye information are the same.

Under such conditions, it is considered that information concerning similarity (hereinafter referred to as similarity information) obtained in generation of differential data (S01) in data compression of one of the fluorescence spectrum and the fluorescent dye information can be used in data compression of the other (mutual use of similarity information).

Therefore, in the present invention, a result (similarity information) obtained in similar sample determination processing in the generation of one differential data (S01) in the compression processing of the fluorescence spectrum is used in the generation of the other differential data (S01) (the fluorescent dye information) to omit similar sample determination processing in the generation of the other differential data (S01). Consequently, since the other compression processing is accelerated, the entire compression processing can be accelerated.

The mutual use of the similarity information can be realized, for example, by managing similarity information (information indicating which sample is similar) for each of samples generated in a process of one compression processing in a database or the like and referring to the similarity information managed in the database or the like in the other compression processing.

Other configurations, operations, and effects may be similar to those in the embodiments explained above. Therefore, detailed explanation thereof is omitted here.

### 3. Third Embodiment

Subsequently, a third embodiment of the present disclosure is explained. Note that, since configurations and operations of a flow cytometer and an information processing system according to the present embodiment may be similar to those of the embodiment explained above, detailed explanation thereof is omitted here.

### 3.1 Acceleration of Cloud transfer by division compression/decoding

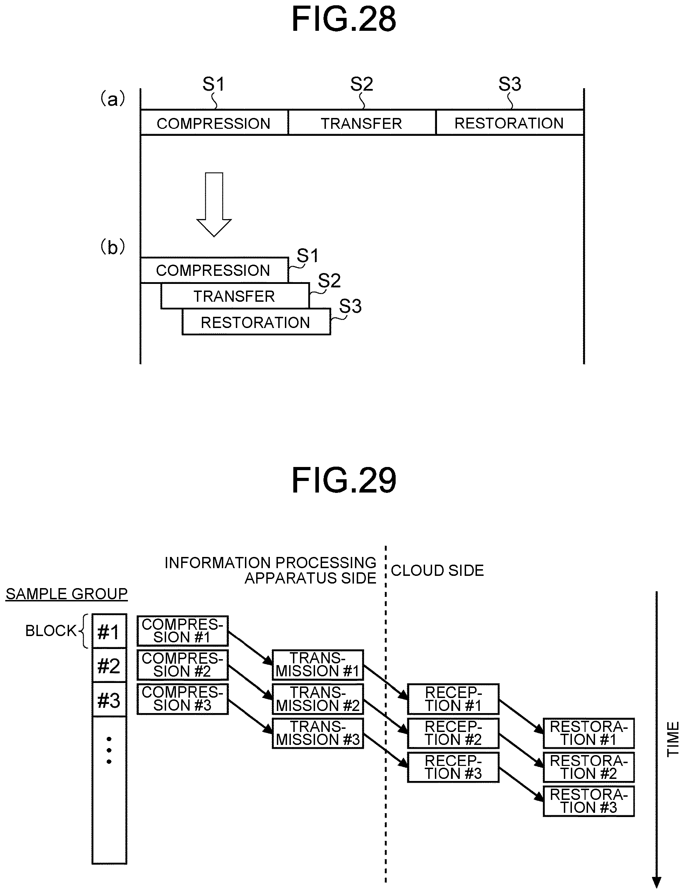

FIG. 28 is a diagram for explaining an execution order example of compression, transfer, and decoding according to the present embodiment, in which (a) is a schematic diagram illustrating a flow of processing in a case where the compression, the transfer, and the decoding are sequentially executed, and (b) is a schematic diagram illustrating a flow of processing in a case where the compression, the transfer, and the decoding are pipelined.

As illustrated in (a) of FIG. 28, when the compression, the data transfer, and the decoding are sequentially executed, after compression processing S1 is executed in the information processing apparatus 2 (see FIG. 3) and all compressed data are collected, transfer S2 of the compressed data is executed from the information processing apparatus 2 to the Cloud 3, and thereafter, after all the compressed data are received on the Cloud 3 side, restoration S3 of the compressed data is executed.

On the other hand, as illustrated in (b) of FIG. 28, when the compression, the data transfer, and the decoding are pipelined and parallel processing is partially executed, without waiting for completion of the compression processing S1 in the information processing apparatus 2 (see FIG. 3), the transfer S2 of the compressed data from the information processing apparatus 2 to the Cloud 3 is executed in order from the generated compressed data and, thereafter, the restoration S3 of the compressed data is executed in order from the compressed data received on the Cloud 3 side. Therefore, by pipelining the compression, the data transfer, and the decoding, it is possible to greatly reduce a time required from the compression of the sample data on the information processing apparatus 2 side to the restoration of the compressed data on the Cloud 3 side.

FIG. 29 is a diagram for explaining an execution order example of the compression, the transfer, and the decoding according to the present embodiment more in detail. As illustrated in FIG. 29, in the present embodiment, the sample group is divided into a plurality of blocks. Each of the blocks may be configured by, for example, approximately several thousand to several hundred thousand samples.

The information processing apparatus 2 executes the compression in units of blocks and transfers (transmits → receives) the compressed data to the Cloud 3 in order from the block for which the compression is completed. The Cloud 3 sequentially restores compressed data received in units of blocks from the information processing apparatus 2.

With such pipelining, compression processing (for example, compression #2 and #3) for the next block is hidden behind transfer processing (for example, transmission #1 and #2 and reception #1) of the preceding block and restoration processing (for example, restoration #1 and #2) for the preceding block is hidden behind transfer processing (for example, transmission #3 and reception #2 and #3) for the next block. Therefore, a processing time from the compression to the restoration for all the sample data can be greatly reduced.

Note that, when data to be compressed is divided into smaller block units, there is a possibility that a data reduction ratio decreases. However, whereas the number of samples is several ten thousand to twenty million or more as in the sample data illustrated in the present embodiment, when the number of types of samples is approximately several hundred, even if a sample group is divided into approximately several thousand to several hundred thousand blocks, a sufficient data reduction ratio can be realized in the blocks.

Other configurations, operations, and effects may be similar to those in the embodiments explained above. Therefore, detailed explanation thereof is omitted here.

The preferred embodiments of the present disclosure are explained in detail above with reference to the accompanying drawings. However, the technical scope of the present disclosure is not limited to such examples. It is evident that those having the ordinary knowledge in the technical field of the present disclosure can arrive at various alterations or corrections within the scope of the appended claims. It is understood that these alterations and corrections naturally belong to the technical scope of the present disclosure.

The effects described in this specification are only explanatory or illustrative and are not limiting. That is, the technique according to the present disclosure can achieve other effects obvious for those skilled in the art from the description of this specification together with or instead of the effects.

### Reference Signs List

1 FLOW CYTOMETER
2 INFORMATION PROCESSING APPARATUS
3 CLOUD
4 TERMINAL
100 LIGHT SOURCE UNIT
101 to 103 EXCITATION LIGHT SOURCE
111, 115 TOTAL REFLECTION MIRROR
112, 113 DICHROIC MIRROR
116 OBJECTIVE LENS
120 MICROCHIP
123a SPOT
130 SCATTERED LIGHT DETECTION UNIT
131, 133, 135 LENS
132 TOTAL REFLECTION MIRROR
134 MASK
136 PHOTODETECTOR
137 DIAPHRAGM

## Claims

1. An information processing system (1) comprising:
an excitation light source (100) that irradiates a respective plurality of samples belonging to a sample group with excitation light;
a measurement unit (142) that measures fluorescence generated by irradiation of the sample with the excitation light; and
an information processing unit (2) that generates differential data based on a difference between similar fluorescence signals among fluorescence signals based on the fluorescence measured for the respective samples;
**characterised in that**
the fluorescence signal includes spectrum information of light generated by irradiating the sample labeled with a fluorescent dye with excitation light and fluorescent dye information of the fluorescent dye obtained from the spectrum information through spectrum un-mixing, and
the information processing unit specifies the similar fluorescent dye information based on a combination of the samples of the respective similar spectrum information specified when a difference between the similar spectrum information is calculated and calculates a difference between the specified similar fluorescent dye information.

2. The information processing system according to claim 1, wherein
the information processing unit sets, as the similar fluorescence signals, a combination having a smallest calculated difference among combinations of two fluorescence signals selected from the plurality of fluorescence signals.

3. The information processing system according to claim 1, wherein
the fluorescence signal includes a plurality of dimensions, and
the information processing unit sets, as the similar fluorescence signals, a combination having either i) a smallest maximum value of a difference calculated between corresponding dimensions among combinations of two fluorescence signals selected from the plurality of fluorescence signals or ii) a highest appearance frequency of a calculated difference among combinations of two fluorescence signals selected from the plurality of fluorescence signals.

4. The information processing system according to claim 1, wherein
the fluorescence signal includes a plurality of dimensions, and
the information processing unit sets, as the similar fluorescence signals, a combination having a largest total of appearance frequencies of differences calculated between corresponding dimensions among combinations of two fluorescence signals selected from the plurality of fluorescence signals.

5. The information processing system according to claim 1, wherein
the information processing unit specifies the similar fluorescence signals using at least one of a Euclidean distance and cosine similarity.

6. The information processing system according to claim 1, wherein
the differential data includes first information for specifying a combination of the similar fluorescence signals used to calculate the difference.

7. The information processing system according to claim 6, wherein,
when a fluorescence signal similar to a first fluorescence signal among the plurality of fluorescence signals is absent in the sample group, the differential data includes predetermined second information instead of the first information.

8. The information processing system according to claim 1, wherein
the information processing unit generates compressed data by compressing the differential data.

9. The information processing system according to claim 8, wherein
the information processing unit compresses the differential data using a reversible compression method.

10. The information processing system according to claim 8, wherein
the information processing unit compresses the differential data using at least one of a method of compressing by reducing unnecessary bit representation, a lexicographic compression method, a compression method using an entropy code, and a compression method using statistical prediction.

11. The information processing system according to claim 9, wherein
the differential data includes information for specifying a most significant bit of the difference, and
the information processing unit compresses the differential data using the reversible compression method including a method of compressing by reducing unnecessary bit representation.

12. The information processing system according to claim 8, further comprising
a transmission unit that transmits the compressed data generated by the information processing unit via a predetermined network.

13. The information processing system according to claim 8, further comprising
a storage unit that stores the compressed data generated by the information processing unit.

## Patentansprüche

1. Informationsverarbeitungssystem (1), umfassend:
eine Anregungslichtquelle (100), die eine jeweilige Vielzahl von Proben, die zu einer Probengruppe gehören, mit Anregungslicht bestrahlt;
eine Messeinheit (142), die Fluoreszenz, die durch Bestrahlung der Probe mit dem Anregungslicht erzeugt wird, misst; und
eine Informationsverarbeitungseinheit (2), die Differentialdaten basierend auf einer Differenz zwischen ähnlichen Fluoreszenzsignalen unter Fluoreszenzsignalen basierend auf der Fluoreszenz, die für die jeweiligen Proben gemessen wird, erzeugt;
**dadurch gekennzeichnet, dass**
das Fluoreszenzsignal Spektrum informationen von Licht, das durch Bestrahlen der Probe, die mit einem Fluoreszenzfarbstoff markiert ist, mit Anregungslicht erzeugt wird, und Fluoreszenzfarbstoffinformationen des Fluoreszenzfarbstoffs einschließt, die aus den **Spektruminformationen durch Spektrumentmischen erhalten werden,** und
die Informationsverarbeitungseinheit die ähnlichen Fluoreszenzfarbstoffinformationen basierend auf einer Kombination der Proben der jeweiligen ähnlichen Spektruminformationen spezifiziert, die spezifiziert werden, wenn eine Differenz zwischen den ähnlichen Spektruminformationen berechnet wird, und eine Differenz zwischen den spezifizierten ähnlichen Fluoreszenzfarbstoffinformationen berechnet.

2. Informationsverarbeitungssystem nach Anspruch 1, wobei
die Informationsverarbeitungseinheit eine Kombination als die ähnlichen Fluoreszenzsignale festlegt, die eine kleinste berechnete Differenz unter Kombinationen von zwei Fluoreszenzsignalen aufweist, die aus der Vielzahl von Fluoreszenzsignalen ausgewählt wurden.

3. Informationsverarbeitungssystem nach Anspruch 1, wobei
das Fluoreszenzsignal eine Vielzahl von Dimensionen einschließt und
die Informationsverarbeitungseinheit eine Kombination als die ähnlichen Fluoreszenzsignale festlegt, die entweder i) einen kleinsten Maximalwert einer Differenz, die zwischen entsprechenden Dimensionen unter Kombinationen von zwei Fluoreszenzsignalen berechnet wird, die aus der Vielzahl von Fluoreszenzsignalen ausgewählt wurden, oder ii) eine höchste Auftrittshäufigkeit einer berechneten Differenz unter Kombinationen von zwei Fluoreszenzsignalen aufweist, die aus der Vielzahl von Fluoreszenzsignalen ausgewählt wurden.

4. Informationsverarbeitungssystem nach Anspruch 1, wobei
das Fluoreszenzsignal eine Vielzahl von Dimensionen einschließt und
die Informationsverarbeitungseinheit eine Kombination als die ähnlichen Fluoreszenzsignalen festlegt, die eine größte Summe von Auftrittshäufigkeiten von Differenzen aufweist, die zwischen entsprechenden Dimensionen unter Kombinationen von zwei Fluoreszenzsignalen berechnet wurden, die aus der Vielzahl von Fluoreszenzsignalen ausgewählt wurden.

5. Informationsverarbeitungssystem nach Anspruch 1, wobei
die Informationsverarbeitungseinheit die ähnlichen Fluoreszenzsignale unter Verwendung von mindestens eines von einem euklidischen Abstand und einer Kosinus-Ähnlichkeit spezifiziert.

6. Informationsverarbeitungssystem nach Anspruch 1, wobei
die Differentialdaten erste Informationen zum Spezifizieren einer Kombination der ähnlichen Fluoreszenzsignale, die verwendet werden, um den Unterschied zu berechnen, einschließen.

7. Informationsverarbeitungssystem nach Anspruch 6, wobei,
wenn ein Fluoreszenzsignal, das einem ersten Fluoreszenzsignal unter der Vielzahl von Fluoreszenzsignalen ähnlich ist, in der Probengruppe fehlt, die Differentialdaten anstelle der ersten Informationen vorbestimmte zweite Informationen einschließen.

8. Informationsverarbeitungssystem nach Anspruch 1, wobei
die Informationsverarbeitungseinheit komprimierte Daten durch Komprimieren der Differentialdaten erzeugt.

9. Informationsverarbeitungssystem nach Anspruch 8, wobei
die Informationsverarbeitungseinheit die Differentialdaten unter Verwendung eines reversiblen Komprimierungsverfahrens komprimiert.

10. Informationsverarbeitungssystem nach Anspruch 8, wobei
die Informationsverarbeitungseinheit die Differentialdaten unter Verwendung von mindestens einem von einem Verfahren zum Komprimieren durch Reduzieren unnötiger Bitdarstellungen, einem lexikografischen Komprimierungsverfahren, einem Komprimierungsverfahren unter Verwendung eines Entropiecodes und einem Komprimierungsverfahren unter Verwendung statistischer Vorhersage komprimiert.

11. Informationsverarbeitungssystem nach Anspruch 9, wobei
die Differentialdaten Informationen zum Spezifizieren eines höchstwertigen Bits der Differenz einschließen und
die Informationsverarbeitungseinheit die Differentialdaten unter Verwendung des reversiblen Komprimierungsverfahrens, einschließlich eines Verfahrens zum Komprimieren durch Reduzieren unnötiger Bitdarstellungen, komprimiert.

12. Informationsverarbeitungssystem nach Anspruch 8, ferner umfassend
eine Übertragungseinheit, die die komprimierten Daten, die durch die Informationsverarbeitungseinheit erzeugt werden, über ein vorbestimmtes Netzwerk überträgt.

13. Informationsverarbeitungssystem nach Anspruch 8, ferner umfassend
eine Speichereinheit, die die komprimierten Daten, die durch die Informationsverarbeitungseinheit erzeugt werden, speichert.

## Revendications

1. Système de traitement d'informations (1) comprenant :
une source de lumière d'excitation (100) qui irradie une pluralité d'échantillons appartenant à un groupe d'échantillons avec une lumière d'excitation ;
une unité de mesure (142) qui mesure la fluorescence générée par l'irradiation de l'échantillon avec la lumière d'excitation ; et
une unité de traitement d'informations (2) qui génère des données différentielles basées sur une différence entre des signaux de fluorescence similaires parmi les signaux de fluorescence basés sur la fluorescence mesurée pour les échantillons respectifs ;
**caractérisé en ce que**
le signal de fluorescence comporte des informations sur le spectre de la lumière générée par l'irradiation de l'échantillon marqué par un colorant fluorescent avec une lumière d'excitation et des informations sur le colorant fluorescent obtenues à partir des **informations sur** le spectre **par le biais d'un non mixage de spectre,** et
l'unité de traitement d'informations spécifie les informations sur le colorant fluorescent similaire sur la base d'une combinaison des échantillons des informations de spectre similaire respectives spécifiées lorsqu'une différence entre les informations sur le spectre similaire est calculée et calcule une différence entre les informations spécifiées sur le colorant fluorescent similaire.

2. Système de traitement d'informations selon la revendication 1, dans lequel,
l'unité de traitement d'informations définit, comme signaux de fluorescence similaires, une combinaison présentant une différence calculée la plus faible parmi les combinaisons de deux signaux de fluorescence sélectionnés dans la pluralité de signaux de fluorescence.

3. Système de traitement d'informations selon la revendication 1, dans lequel,
le signal de fluorescence comporte une pluralité de dimensions, et
l'unité de traitement d'informations définit, comme signaux de fluorescence similaires, une combinaison présentant soit i) une valeur maximale la plus faible d'une différence calculée entre des dimensions correspondantes parmi des combinaisons de deux signaux de fluorescence sélectionnés parmi la pluralité de signaux de fluorescence, soit ii) une fréquence d'apparition la plus élevée d'une différence calculée parmi des combinaisons de deux signaux de fluorescence sélectionnés dans la pluralité de signaux de fluorescence.

4. Système de traitement d'informations selon la revendication 1, dans lequel,
le signal de fluorescence comporte une pluralité de dimensions, et
l'unité de traitement d'informations définit, comme signaux de fluorescence similaires, une combinaison présentant un total le plus élevé de fréquences d'apparition de différences calculées entre des dimensions correspondantes parmi des combinaisons de deux signaux de fluorescence sélectionnés parmi la pluralité de signaux de fluorescence.

5. Système de traitement d'informations selon la revendication 1, dans lequel,
l'unité de traitement d'informations spécifie les signaux de fluorescence similaires à l'aide d'au moins une distance euclidienne et d'une similarité cosinus.

6. Système de traitement d'informations selon la revendication 1, dans lequel,
les données différentielles comportent une première information permettant de spécifier une combinaison des signaux de fluorescence similaires utilisés pour calculer la différence.

7. Système de traitement d'informations selon la revendication 6, dans lequel,
lorsqu'un signal de fluorescence similaire à un premier signal de fluorescence parmi la pluralité de signaux de fluorescence est absent dans le groupe d'échantillons, les données différentielles comportent une seconde information prédéterminée au lieu de la première information.

8. Système de traitement d'informations selon la revendication 1, dans lequel,
l'unité de traitement de l'information génère des données comprimées en comprimant les données différentielles.

9. Système de traitement d'informations selon la revendication 8, dans lequel,
l'unité de traitement d'informations compresse les données différentielles à l'aide d'une méthode de compression réversible.

10. Système de traitement d'informations selon la revendication 8, dans lequel,
l'unité de traitement d'informations compresse les données différentielles à l'aide d'au moins l'une des méthodes parmi une méthode de compression par réduction de la représentation des bits inutiles, une méthode de compression lexicographique, une méthode de compression utilisant un code d'entropie et une méthode de compression utilisant la prédiction statistique.

11. Système de traitement d'informations selon la revendication 9, dans lequel
les données différentielles comportent des informations permettant de spécifier un bit le plus significatif de la différence, et
l'unité de traitement d'informations compresse les données différentielles à l'aide de la méthode de compression réversible comprenant une méthode de compression par réduction de la représentation des bits inutiles.

12. Dispositif de traitement d'informations selon la revendication 8, comprenant en outre
une unité de transmission qui transmet les données comprimées générées par l'unité de traitement d'informations par le biais d'un réseau prédéterminé.

13. Dispositif de traitement d'informations selon la revendication 8, comprenant en outre
une unité de stockage qui stocke les données comprimées générées par l'unité de traitement d'informations.
